# EUROPEAN PATENT APPLICATION

(11) **EP 4 738 433 A1**
(43) Date of publication of application: **06.05.2026**
(21) Application number: 24831331.4
(22) Date of filing: 01.03.2024
(51) Int. Cl.: H01L 23/29, C08G 59/02, C08K 3/013, C08L 57/00, C08L 63/00, H01L 21/56

(54) **LIQUID COMPRESSION MOLDING MATERIAL, ELECTRONIC COMPONENT, SEMICONDUCTOR DEVICE, AND METHOD FOR MANUFACTURING ELECTRONIC COMPONENT**

(30) Priority: 27.06.2023 JP 2023104856
(71) Applicant: Namics Corporation, Niigata-shi, Niigata 950-3131 (JP)
(72) Inventor: AOYAMA Kyota, Niigata-shi, Niigata 950-3131 (JP); SHIGENO Yuto, Niigata-shi, Niigata 950-3131 (JP); IKEDA Yukihiro, Niigata-shi, Niigata 950-3131 (JP)
(74) Representative: Mathys & Squire
(86) International application number: PCT/JP2024/007867
(87) International publication number: WO 2025/004453

(57) **Abstract**

To suppress occurrence of mold flash during compression molding. A liquid compression molding material containing an epoxy resin (A), a curing agent (B), an inorganic filler (C), and a vinyl-based polymer (D), an electronic component and a semiconductor device manufactured using the same, and a method for manufacturing the electronic component using the same.

## Description

### TECHNICAL FIELD

The present invention relates to a liquid compression molding material, an electronic component, a semiconductor device, and a method for manufacturing the electronic component.

### BACKGROUND ART

Most of semiconductor elements such as integrated circuits constituting the semiconductor device are sealed with a sealing material. There are a plurality of molding methods for sealing the semiconductor element, but in recent years, compression molding which is more suitable for manufacturing a relatively large molded article has been increasingly adopted for sealing the semiconductor element. This is due to spread of wafer-level chip size package technology (technology for sealing a wafer in a state after completion of circuit formation and before separation into individual chips as it is), and the like.

As a conventional curable resin composition used for sealing the semiconductor element by compression molding, a solid resin composition such as a granular resin composition has been mainly used. However, recently, with development of a new compression molding technology, a liquid curable resin composition (so-called liquid compression molding material) is also often used. Therefore, various LCM materials have been proposed (for example, PATENT LITERATURE 1). Hereinafter, the liquid compression molding material may be abbreviated as "liquid compression molding (LCM) material".

### CITATION LIST

### PATENT LITERATURE

PATENT LITERATURE 1: JP-A-2016-108367

### SUMMARY OF INVENTION

### PROBLEMS TO BE SOLVED BY INVENTION

On the other hand, when the compression molding is performed using a conventional LCM material, a phenomenon (mold flash) may occur in which the LCM material leaks out to a region (a surface of the lower mold not covered with the substrate) on an outer peripheral side of a substrate such as a wafer disposed on a lower mold of a compression molding apparatus. Then, when the mold flash occurs, since the leaking LCM material enters device details such as vacuum piping, an operation of the compression molding apparatus needs to be stopped for repair or maintenance, resulting in a decrease in productivity and an increase in manufacturing cost.

The present invention has been made in view of the above circumstances, and an object of the present invention is to provide an LCM material capable of suppressing occurrence of the mold flash during compression molding, an electronic component and a semiconductor device manufactured using the LCM material, and a method for manufacturing the electronic component using the LCM material.

### SOLUTION TO PROBLEMS

The above-described object is achieved by the following present invention. That is,
the liquid compression molding material according to the present invention contains an epoxy resin (A), a curing agent (B), an inorganic filler (C), and a vinyl-based polymer (D).

In an embodiment of the liquid compression molding material according to the present invention, a content of the vinyl-based polymer (D) with respect to 100 parts by mass of the epoxy resin (A) is preferably 0.004 parts by mass to 15 parts by mass.

In another embodiment of the liquid compression molding material according to the present invention, a content of the vinyl-based polymer (D) with respect to 100 parts by mass of the epoxy resin (A) is preferably 0.5 parts by mass to 15 parts by mass.

In another embodiment of the liquid compression molding material according to the present invention, a blending ratio of the inorganic filler (C) to all components constituting the liquid compression molding material is preferably 60 mass% to 90 mass%.

In another embodiment of the liquid compression molding material according to the present invention, the vinyl-based polymer (D) preferably contains at least one vinyl ether polymer.

In another embodiment of the liquid compression molding material according to the present invention, the vinyl-based polymer (D) preferably has a number average molecular weight of 1000 to 150000.

Another embodiment of the liquid compression molding material according to the present invention preferably further contains a solvent (E).

In another embodiment of the liquid compression molding material according to the present invention, a maximum diameter of a cured product of the liquid compression molding material obtained by a half-shot test performed under conditions of pre-stirring and defoaming for 90 minutes, a clamping force of 10 kN, a supply amount of the liquid compression molding material of 11.2 cm³, and static degassing at 200hPa is preferably less than 280 mm.

In another embodiment of the liquid compression molding material according to the present invention, the epoxy resin (A) preferably contains one or more selected from the group consisting of aminophenol type epoxy, bisphenol A type epoxy, bisphenol F type epoxy, glycidylamine type epoxy, and polytetramethylene glycol diglycidyl ether.

In another embodiment of the liquid compression molding material according to the present invention, the curing agent (B) is preferably an imidazole-based curing agent.

The liquid compression molding material according to the present invention preferably has a viscosity at 120°C of 0.3 Pa·s to 30 Pa·s.

An electronic component according to the present invention includes a sealing material containing a cured product of the liquid compression molding material of the present invention.

A semiconductor device according to the present invention includes a substrate, a semiconductor element disposed on the substrate, and a cured product of the liquid compression molding material of the present invention, the cured product sealing a gap between the semiconductor element and the substrate.

A method for manufacturing an electronic component according to the present invention includes at least a compression molding step using the liquid compression molding material according to the present invention, to manufacture the electronic component including a substrate, an element disposed on the substrate, and a sealing material containing a cured product of the liquid compression molding material sealing a gap between the element and the substrate.

### EFFECTS OF INVENTION

According to the present invention, it is possible to provide the LCM material capable of suppressing occurrence of mold flash during compression molding, the electronic component and the semiconductor device manufactured using the LCM material, and the method for manufacturing the electronic component using the LCM material.

### BRIEF DESCRIPTION OF DRAWINGS

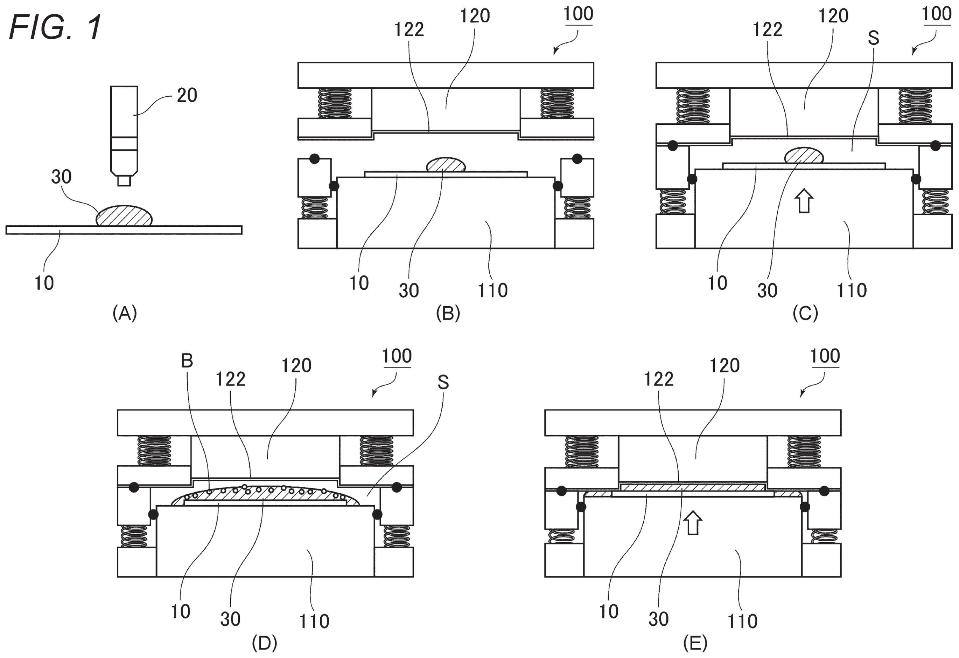

Fig. 1 is a schematic view for explaining occurrence of mold flash in a compression molding process using an LCM material.

### DESCRIPTION OF EMBODIMENTS

### <LCM material>

The LCM material of the present embodiment contains an epoxy resin (A), a curing agent (B), an inorganic filler (C), and a vinyl-based polymer (D). The LCM material of the present embodiment can suppress occurrence of mold flash during compression molding because the vinyl-based polymer (D) is used.

Background of finding the LCM material of the present embodiment by the present inventors is as follows. First, the occurrence of the mold flash in a compression molding process using the LCM material will be described with reference to Fig. 1. Note that when an electronic component such as a semiconductor device is manufactured by compression molding using the LCM material, various substrates such as a wafer and various elements such as a semiconductor element which is an object to be sealed are used in addition to the LCM material, but description of the elements is omitted in Fig. 1.

As illustrated in Fig. 1, in the compression molding process, first, an LCM material 30 is supplied onto a substrate 10 such as a wafer by an LCM material supply means 20 (Fig. 1(A), LCM material supply step). In the LCM material supply step, the LCM material 30 is supplied to cover a vicinity of a central portion of the substrate 10. Next, the substrate 10 supplied with the LCM material 30 is disposed on a lower mold 110 of a compression molding apparatus 100 (Fig. 1(B): substrate placement step). Note that as illustrated in Fig. 1(B), as the substrate 10 used for compression molding, a substrate having a horizontal size smaller than that of an upper surface of the lower mold 110 is used. In addition, the lower mold 110 and an upper mold 120 are heated to a molding temperature (for example, 120°C) before the substrate placement step is performed. Therefore, the LCM material 30 continues to be heated by the lower mold 110 via the substrate 10 from a time point when the substrate placement step (Fig. 1(B)) is completed.

Subsequently, by closing the mold, a sealed space S surrounded by the lower mold 110 and the upper mold 120 having a surface covered with a release film 122 is formed (Fig. 1(C), mold closing step). Then, air in the sealed space S formed by closing the mold is degassed by a pressure reducing means (Fig. 1(D), degassing step). After an inside of the sealed space S is sufficiently depressurized, by relatively moving both the molds 110 and 120 so that the lower mold 110 further approaches the upper mold 120, the LCM material 30 is pressurized by the substrate 10 on the lower mold 110, and the upper mold 120, and at the same time, the LCM material 30 thinly spread in a horizontal direction is further heated from both upper and lower surfaces to be preliminarily cured (Fig. 1(E), heating and pressurizing step).

In the compression molding process illustrated in Fig. 1, in the degassing step (Fig. 1(D)), air bubbles B included in the LCM material 30 spreads to cause volume expansion of the LCM material 30, and thus the LCM material 30 spreads in the horizontal direction, and further, in the heating and pressurizing step (Fig. 1(E)), the LCM material 30 further spreads in the horizontal direction. Then, at an end of the heating and pressurizing step, as illustrated in Fig. 5(E), when an outer peripheral end of a cured product of the LCM material 30 that has completely spread in the horizontal direction is located on an outer peripheral side of the substrate 10 (a surface of a portion of the lower mold 110 not covered with the substrate), it means that the mold flash has occurred. Here, if the volume expansion of the LCM material 30 in the degassing step (Fig. 1(D)) is zero, a degree of spread of the LCM material 30 in the horizontal direction, which affects the occurrence of the mold flash, can be extremely easily controlled by appropriately selecting (a) a supply amount of the LCM material 30 supplied onto the substrate 10 and (b) a size of a gap formed between the lower mold 110 and the upper mold 120 at the end of the heating and pressurizing step. Therefore, it is considered that the occurrence of the mold flash can be easily suppressed if (c) expansion of the air bubbles B included in the LCM material 30 in the degassing step (Fig. 1(D)) can be further suppressed after appropriate conditions are set for the above (a) and (b).

Based on the above-mentioned new findings, the present inventors have considered that it is extremely important to prevent generation of the air bubbles B or to eliminate the air bubbles B in the degassing step in order to suppress volume expansion of the LCM material 30 due to the expansion of the air bubbles B contained in the LCM material 30 in the degassing step (Fig. 1(D)). On the other hand, when a liquid composition is manufactured by mixing and stirring various raw materials, it is known to use an antifoaming agent in order to prevent the generation of the air bubbles generated in the liquid composition in a manufacturing process or to eliminate the air bubbles generated in the liquid composition.

Therefore, the present inventors considered that when an existing antifoaming agent is blended in the LCM material 30, regardless of a type of the antifoaming agent, the mold flash caused by the volume expansion in the degassing step (Fig. 1(D)) can be easily suppressed. However, as a result of trial and error by the present inventors, it has been found that any of a wide variety of antifoaming agents is not effective for suppressing the mold flash, and only an antifoaming agent obtained by dissolving a vinyl-based polymer as a main component in a solvent can suppress the mold flash. From this result, the present inventors have considered that only the vinyl-based polymer among various main components used as the antifoaming agent has some unique action and effect of suppressing the volume expansion of the LCM material 30 in the degassing step (Fig. 1(D)), and has found the LCM material of the present embodiment.

Next, various components constituting the LCM material of the present embodiment will be described in detail below.

### (A) Epoxy resin

The epoxy resin used for the LCM material of the present embodiment is not particularly limited as long as it is any of various epoxy resins generally used for semiconductor sealing, but it is preferable to use a liquid epoxy resin from the viewpoint of fluidity during molding. Further, as the epoxy resin to be blended in the LCM material, only one type of epoxy resin may be used, or two or more types of epoxy resins may be used in combination. Representative specific examples of the epoxy resin include an aromatic epoxy resin and an aliphatic epoxy resin. Examples of the aromatic epoxy resin include: bisphenol A type epoxy resins such as p-glycidyloxyphenyldimethyltrisbisphenol A diglycidyl ether; bisphenol F type epoxy resin; novolac type epoxy resin; fluorene type epoxy resin; biphenyl aralkyl epoxy resin; diepoxy resins such as p-tert-butyl phenyl glycidyl ether and 1,4-phenyldimethanol diglycidyl ether; biphenyl type epoxy resins such as 3,3',5,5'-tetramethyl-4,4'-diglycidyloxybiphenyl; aminophenol type epoxy resins such as diglycidyl aniline, diglycidyl toluidine, triglycidyl-p-aminophenol, and tetraglycidyl-m-xylylenediamine; naphthalene type epoxy resin; glycidylamine type epoxy resin; and epoxy resin having a plant-derived skeleton, but the present invention is not limited thereto.

Examples of the aliphatic epoxy resin include: monofunctional aliphatic epoxy compounds having one epoxy group in the molecule, such as alkyl alcohol glycidyl ether [butyl glycidyl ether, 2-ethylhexyl glycidyl ether, and the like] and alkenyl alcohol glycidyl ether [vinyl glycidyl ether, allyl glycidyl ether, and the like]; bifunctional aliphatic epoxy compounds having two epoxy groups in the molecule, such as polyalkylene glycol diglycidyl ether such as polyalkylene glycol diglycidyl ether and polytetramethylene glycol diglycidyl ether, and alkenylene glycol diglycidyl ether; and polyfunctional aliphatic epoxy compounds having three or more epoxy groups in the molecule, such as polyglycidyl ethers [trimethylolpropane triglycidyl ether, pentaerythritol (tri or tetra) glycidyl ether, dipentaerythritol (tri, tetra, penta or hexa) glycidyl ether, and the like] of trifunctional or higher alcohols such as trimethylolpropane, pentaerythritol, and dipentaerythritol.

Among the above, liquid aminophenol type epoxy, liquid bisphenol A type epoxy, liquid bisphenol F type epoxy, glycidylamine type epoxy, and polytetramethylene glycol diglycidyl ether are preferable from the viewpoint of workability. A content of the epoxy resin (A) with respect to an entire LCM material is preferably 5 mass% to 40 mass%, more preferably 5 mass% to 35 mass%, and still more preferably 7 mass% to 30 mass%.

### (B) Curing agent

As the curing agent used in the LCM material of the present embodiment, any known curing agent for the epoxy resin can be used, and examples thereof include imidazole-based curing agents, amine-based curing agents, phenolic curing agents, and acid anhydride-based curing agents. Among them, the imidazole-based curing agent may be in the form of a latent curing agent that is activated by heating, or may be in the form of a microcapsule-type curing agent. In the LCM material of the present embodiment, the imidazole-based curing agent is preferably used. Further, from the viewpoint of reducing warpage of the cured product of the LCM material, it is preferable to use the phenolic curing agent and the acid anhydride-based curing agent in combination.

Examples of the imidazole-based curing agent include: imidazole; 2-substituted imidazole compounds such as 2-methylimidazole, 2-ethylimidazole, 1-isobutyl-2-methylimidazole, 2-ethyl-4-methylimidazole, 2-phenylimidazole, 2-phenyl-4-methylimidazole, 2-phenyl-4-methyl-5-hydroxymethylimidazole, 1-benzyl-2-methylimidazole, 1-benzyl-2-phenylimidazole, 1,2-dimethylimidazole, 1-cyanoethyl-2-methylimidazole, 1-cyanoethyl-2-ethyl-4-methylimidazole, 1-cyanoethyl-2-undecylimidazole, and 1-cyanoethyl-2-phenylimidazole; 1-cyanoethyl-2-undecylimidazole trimethylimidazole, and 1-cyanoethyl-2-phenylimidazole; trimellitic acid salts such as 1-cyanoethyl-2-undecylimidazolium trimellitate and 1-cyanoethyl-2-phenylimidazolium trimellitate; triazine ring-containing compounds such as 2,4-diamino-6-[(2-methyl-1-imidazolyl)ethyl]s-triazine, 2,4-diamino-6-[(2-undecyl-1-imidazolyl)ethyl]s-triazine, and 2,4-diamino-6-[(2-ethyl-4-methyl-1-imidazolyl)ethyl]s-triazine; isocyanuric acid adduct of 2,4-diamino-6-[(2-methyl-1-imidazolyl)ethyl]s-triazine; isocyanuric acid adduct of 2-phenylimidazole; isocyanuric acid adduct of 2-methylimidazole; isocyanuric acid adduct of 2-phenyl-4,5-dihydroxymethylimidazole; and isocyanuric acid adduct of 2-phenyl-4-methyl-5-hydroxymethylimidazole.

Examples of the amine-based curing agent include: aliphatic amines such as diethylenetriamine, triethylenetetraamine, tetraethylenepentamine, trimethylhexamethylenediamine, m-xylenediamine, and 2-methylpentamethylenediamine; alicyclic polyamines such as isophoronediamine, 1,3-bisaminomethylcyclohexane, bis(4-aminocyclohexyl)methane, norbomenediamine, and 1,2-diaminocyclohexane; aliphatic amines such as piperazine-type polyamines such as N-aminoethylpiperazine and 1,4-bis(2-amino-2-methylpropyl)piperazine; aromatic amines such as diaminodiphenylmethane, m-phenylenediamine, diaminodiphenylsulfone, diethyltoluenediamine, trimethylenebis(4-aminobenzoate), polytetramethyleneoxide-di-p-aminobenzoate, and 4,4'-diamino-3,3'-diethyldiphenylmethane.

As the phenolic curing agent, a phenolic resin, particularly a novolac resin obtained by condensing phenols or naphthols (for example, phenol, cresol, naphthol, alkylphenol, bisphenol, terpene phenol, and the like) with formaldehyde is preferably used. Examples of the novolac resin include a phenol novolac resin, an o-cresol novolac resin, a p-cresol novolac resin, an α-naphthol novolac resin, a β-naphthol novolac resin, a t-butylphenol novolac resin, a bisphenol A-type novolac resin, a xylylene-modified novolac resin, and a decaline-modified novolac resin. Examples of other phenolic resins include a dicyclopentadiene cresol resin, polypara-vinylphenol, poly(di-o-hydroxyphenyl)methane, poly(di-m-hydroxyphenyl)methane, and poly(di-p-hydroxyphenyl)methane.

Examples of the acid anhydride-based curing agent include phthalic anhydride, alkylhexahydrophthalic anhydride such as hexahydrophthalic anhydride and methylhexahydrophthalic anhydride, alkyltetrahydrophthalic anhydride such as tetrahydrophthalic anhydride, trialkyltetrahydrophthalic anhydride and 3-methyltetrahydrophthalic anhydride, hymic anhydride, succinic anhydride, trimellitic anhydride, and pyromellitic anhydride.

Among the curing agents listed above, the imidazole-based curing agent is preferable from the viewpoint of reactivity at a high temperature and storage stability. Further, in the LCM material of the present embodiment, only one type of curing agent may be used as the curing agent (B), or two or more types of curing agents may be used in combination. A blending amount of the curing agent (B) in the LCM material of the present embodiment is preferably 1 to 100 parts by mass, more preferably 3 to 98 parts by mass, and particularly preferably 4 to 95 parts by mass with respect to 100 parts by mass of the epoxy resin (A).

### (C) Inorganic filler

The inorganic filler is not particularly limited and any known inorganic filler can be used as long as it has an effect of reducing a thermal expansion coefficient of the cured product of the LCM material of the present embodiment. Examples of materials of the inorganic filler include silica, alumina, aluminum, aluminum nitride, silicon carbide, and silicon nitride. As the inorganic filler, a silica inorganic filler is particularly suitable from the viewpoint of increasing the blending amount (filling amount) of the inorganic filler with respect to the LCM material. Further, the inorganic filler may be surface-treated with a surface treatment agent such as a silane coupling agent. Further, as the inorganic filler blended in the LCM material, only one type of inorganic filler may be used, or two or more types of inorganic fillers may be used in combination.

A shape of the inorganic filler is not particularly limited, and may be any shape such as a spherical shape, an amorphous shape, or a flaky shape. In addition, an average particle diameter of the inorganic filler is preferably 0.005 µm to 10.0 µm, more preferably 0.01 µm to 5.0 µm, and still more preferably 0.03 µm to 3.0 µm. Note that the average particle diameter means a volume average particle diameter D50 (a particle diameter at which a cumulative value from a small diameter side of a volume-based particle size distribution is 50%) value measured using a laser diffraction particle size distribution measuring apparatus. From the viewpoint of further lowering the viscosity of the LCM material while maintaining a content of the inorganic filler blended in the LCM material high, it is preferable to use two types of inorganic fillers having different volume average particle diameters D50 in combination. A blending ratio of the inorganic filler (C) to all the components constituting the LCM material is preferably 60 mass% to 90 mass%, and more preferably 65 mass% to 90 mass%. By setting the content within the above numerical range, since a linear expansion coefficient of the cured product of the LCM material can be reduced, it is easy to reduce warpage of the electronic component such as the semiconductor device manufactured using the LCM material.

### (D) Vinyl-based polymer

As the vinyl-based polymer, any known vinyl-based polymer can be used. As a raw material used for manufacturing the LCM material, a vinyl-based polymer can be used alone, but from the viewpoint of easy availability of the material, it is preferable to use the vinyl-based polymer antifoaming agent obtained by dissolving the vinyl-based polymer in the solvent. As the vinyl-based polymer antifoaming agent, for example, commercially available products such as SN-353 (manufactured by SAN NOPCO LIMITED), BYK-1759 (manufactured by BYK JAPAN KK), and LHP-90 (manufactured by Kusumoto Chemicals, Ltd.) can be appropriately used.

Note that the vinyl-based polymer antifoaming agent containing the vinyl-based polymer as an active component is usually an additive used for the purpose of eliminating the air bubbles generated when the liquid composition is prepared by mixing and stirring various raw materials at normal temperature (around 25°C), similarly to other conventionally known antifoaming agents such as a silicone-based antifoaming agent and an acrylic antifoaming agent. Then, as shown in experimental data described later, performance of the vinyl-based polymer antifoaming agent is comparable to or slightly inferior to other conventionally known antifoaming agents when used as a normal antifoaming agent described above, however, when the vinyl-based polymer antifoaming agent is used for the purpose of suppressing the occurrence of the mold flash, the vinyl-based polymer antifoaming agent exhibits remarkably excellent performance as compared to other conventionally known antifoaming agents. A reason why only the vinyl-based polymer antifoaming agent among various conventionally known antifoaming agents exhibits remarkably excellent performance from the viewpoint of suppressing the occurrence of the mold flash is not clear, but in view of facts shown in the following (1) and (2), it is presumed that this is because only the vinyl-based polymer antifoaming agent can exhibit excellent antifoaming action even in a state of being heated to a temperature significantly higher than the normal temperature (around 25°C) compared to other antifoaming agents.
(1) In the compression molding process, the occurrence of the mold flash is due to the expansion of the air bubbles B contained in the LCM material 30 in the degassing step (Fig. 1(D)).
(2) Before performing the degassing step (Fig. 1(D)), since the lower mold 110 has already been sufficiently heated to a temperature significantly higher than the normal temperature, the LCM material 30 is also inevitably heated by the lower mold 110 via the substrate 10 in the degassing step (Fig. 1 (D)).

The vinyl-based polymer can be used without particular limitation as long as it is a polymer obtained by a polymerization reaction of a vinyl-based monomer. Specific examples of the vinyl-based polymer include vinyl ether polymers such as polymethyl vinyl ether, polyethyl vinyl ether, poly-n-propyl vinyl ether, polyisopropyl vinyl ether, polybutyl vinyl ether, polyisobutyl vinyl ether, poly-t-butyl vinyl ether, polypentyl vinyl ether, polyhexyl vinyl ether, and poly-2-ethylhexyl vinyl ether, and among them, polyisobutyl vinyl ether is preferable from the viewpoint of particularly excellent antifoaming effect in the degassing step (Fig. 1(D)) in the compression molding process.

In addition, the vinyl-based polymer may be any type of polymer of (a) a homopolymer, (b) a copolymer obtained by copolymerizing two or more vinyl-based monomers, and (c) a copolymer obtained by copolymerizing the vinyl-based monomer and another monomer. Here, the "copolymer" of the type (c) means a copolymer in which a proportion of the vinyl-based monomer in all monomers used for copolymerization is 10 mol% or more, and the proportion of the vinyl-based monomer in all the monomers is preferably 15 mol% or more, and more preferably 20 mol% or more. Note that examples of commercially available products of the copolymer of the type (c) include the above-described BYK-1759. Examples of other monomers copolymerizable with the vinyl-based monomer include acrylates such as butyl acrylate, allyl ethers such as allyl phenyl ether, allyl esters such as allyl acetate, maleimides such as N-phenylmaleimide and N-cyclohexylmaleimide, fumaric acid diesters such as diisopropyl fumarate and dicyclohexyl fumarate, maleic anhydride, and itaconic anhydride.

A content of the vinyl-based polymer (D) is not particularly limited as long as the occurrence of the mold flash can be suppressed, but is preferably 0.001 parts by mass or more, more preferably 0.002 parts by mass or more, still more preferably 0.09 parts by mass or more, and particularly preferably 0.9 parts by mass or more with respect to 100 parts by mass of a total content of the epoxy resin (A), the curing agent (B), and the inorganic filler (C). By setting the content of the vinyl-based polymer (D) to 0.001 parts by mass or more with respect to 100 parts by mass of the total content of components (A) to (C), the occurrence of the mold flash can be more reliably suppressed, and by setting the content to 0.09 parts by mass or more, warpage of a sealed article (an electronic component such as the semiconductor device) obtained through the compression molding process can also be suppressed.

Note that from the viewpoint of suppressing the generation of the mold flash and further suppressing the warpage, the content of the vinyl-based polymer (D) with respect to 100 parts by mass of the total content of the components (A) to (C) should be as large as possible, however, when the content is too large, peeling may occur at an interface between various elements such as semiconductor elements constituting the sealed article and a sealing material (cured product of the LCM material) for sealing the element, leading to deterioration of reliability of the sealed article. Therefore, an upper limit value of the content of the vinyl-based polymer (D) with respect to 100 parts by mass of the total content of the components (A) to (C) is preferably 3.0 parts by mass or less, more preferably 2.5 parts by mass or less, and still more preferably 2.0 parts by mass or less.

In addition, the content of the vinyl-based polymer (D) with respect to 100 parts by mass of the epoxy resin (A) is not particularly limited as long as the occurrence of the mold flash can be suppressed, but a lower limit value is preferably 0.004 parts by mass or more, more preferably 0.008 parts by mass or more, still more preferably 0.5 parts by mass or more, and particularly preferably 5 parts by mass or more. By setting the content of the vinyl-based polymer (D) to 0.004 parts by mass or more with respect to 100 parts by mass of the epoxy resin (A), the occurrence of the mold flash can be more reliably suppressed, and by setting the content to 0.5 parts by mass or more, the warpage of the sealed article (electronic component such as the semiconductor device) obtained through the compression molding process can also be suppressed. Details of a reason why the warpage of the sealed article can be suppressed are not clear, but the present inventors presume that the warpage is suppressed for the reason described below. That is, when the content of the vinyl-based polymer (D) with respect to 100 parts by mass of the epoxy resin (A) is 0.5 parts by mass or more, a part of the vinyl-based polymer is dissolved in the LCM material, but the rest of the vinyl-based polymer is dispersed in the LCM material without being dissolved. Then, when the LCM material is cured, the vinyl-based polymer not dissolved in the LCM material contributes to alleviating stress in the cured body generated at the time of curing. At this time, as the content of the vinyl-based polymer increases, an amount (in other words, an amount of the vinyl-based polymer contributing to alleviating the stress in the cured body generated at the time of curing) of the vinyl-based polymer present without being dissolved in the LCM material also increases. For this reason, it is presumed that the warpage of the sealed article is suppressed.

Note that from the viewpoint of suppressing the occurrence of the mold flash and further suppressing the warpage, the content of the vinyl-based polymer (D) with respect to 100 parts by mass of the component (A) should be as large as possible, however, when the content is too large, the peeling may occur at the interface between various elements such as semiconductor elements constituting the sealed article and the sealing material (cured product of the LCM material) for sealing the elements, leading to deterioration of the reliability of the sealed article. Therefore, the upper limit value of the content of the vinyl-based polymer (D) with respect to 100 parts by mass of the component (A) is preferably 15 parts by mass or less, more preferably 10 parts by mass or less, and still more preferably 8.0 parts by mass or less.

A number average molecular weight of the vinyl-based polymer is not particularly limited, but is preferably 1000 to 150000, more preferably 1500 to 100000, and still more preferably 2000 to 80000. Note that in the present specification, the number average molecular weight means a number average molecular weight in terms of polystyrene measured by gel permeation chromatography (GPC) measurement. By setting the number average molecular weight of the vinyl-based polymer within the above range, even when the content of the vinyl-based polymer (D) contained in the LCM material of the present embodiment is smaller, it is easier to suppress the occurrence of the mold flash and to suppress the warpage. In addition, influence on various physical properties (for example, viscosity, glass transition temperature Tg, and the like) of the LCM material and the cured product thereof due to blending of the vinyl-based polymer can be further reduced.

### Other components

In the LCM material of the present embodiment, other components other than the components (A) to (D) may be further blended as necessary. The other components are not particularly limited, and examples thereof include a curing accelerator, a coupling agent, a pigment, an ion trapping agent, a leveling agent, an antioxidant, a flame retardant, a coloring agent, a reactive diluent, an elastomer, a solvent, and an antifoaming agent containing a component other than a vinyl-based polymer as the active component. Blending amounts of the other components can be appropriately selected according to the type thereof. Note that when the vinyl-based polymer antifoaming agent obtained by dissolving the vinyl-based polymer in the solvent is used as the raw material for manufacturing the LCM material, the LCM material of the present embodiment also contains a solvent derived from the vinyl-based polymer antifoaming agent.

When the solvent is also blended in the LCM material, a boiling point of the solvent to be blended is preferably 160°C or lower. Since the compression molding is generally performed at a temperature of 160°C or lower, when the LCM material contains a solvent having a boiling point higher than 160°C, a solvent component in the LCM material is not volatilized in the compression molding process, which may cause cracks and voids. In addition to this, the viscosity of the LCM material is decreased (the fluidity is increased), and there is a tendency that the mold flash easily occurs, and in addition, there is an increased possibility that curability is deteriorated or reliability is deteriorated due to the peeling. Examples of the solvent having a boiling point of 160°C or lower include ethyl acetate, butyl acetate, methyl isobutyl ketone, and methoxypropyl acetate. Therefore, when the vinyl-based polymer antifoaming agent is used as the raw material used for manufacturing the LCM material, the solvent contained in the vinyl-based polymer antifoaming agent is preferably the above-described solvent having a boiling point of 160°C or lower. Further, a content of the solvent (E) contained in the LCM material is preferably 0 mass% to 10 mass%, and more preferably 0 mass% to 5 mass% with respect to a total amount of the LCM material.

Next, suitable physical properties of the LCM material of the present embodiment and the cured product thereof will be described below. The viscosity of the LCM material of the present embodiment is not particularly limited as long as it is liquid at normal temperature, but the viscosity at 25°C is preferably 1000 Pa·s or less, more preferably 600 Pa·s or less, and still more preferably 300 Pa·s or less. When the viscosity at 25°C is 1000 Pa·s or less, it is easy to increase productivity during compression molding. Note that a lower limit value of the viscosity at 25°C is not particularly limited, but when the viscosity is too low (the fluidity of the LCM material is too high), the LCM material easily spreads in the horizontal direction during compression molding, and as a result, the mold flash also easily occurs, and thus the viscosity is practically preferably 40 Pa·s or more, and more preferably 80 Pa·s or more.

The viscosity at 120°C is preferably 30 Pa·s or less, more preferably 10 Pa·s or less, and still more preferably 2 Pa·s or less. By setting the viscosity at 120°C to 30 Pa·s or less, in the degassing step (Fig. 1(D)), the air bubbles B in the LCM material 30 in a heated state easily escape to an outside, and as a result, it is easier to suppress the occurrence of the mold flash. Note that the lower limit value of the viscosity at 120°C is not particularly limited, but when the viscosity is too low (the fluidity of the LCM material is too high), the LCM material easily spreads in the horizontal direction during compression molding, and as a result, the mold flash also easily occurs, and thus the viscosity is practically preferably 0.3 Pa·s or more, and more preferably 0.5 Pa·s or more.

A gel time of the LCM material of the present embodiment at 120°C is preferably 100 seconds to 1000 seconds, more preferably 100 seconds to 800 seconds, and still more preferably 100 seconds to 650 seconds. By setting the gel time to 100 seconds or more, the compression molding can be reliably performed without the LCM material being cured during a period from supply of the LCM material onto the substrate to start of pressure heating by the mold, and by setting the gel time to 1000 seconds or less, high productivity can be easily secured.

The glass transition temperature (Tg) of the cured product of the LCM material of the present embodiment is preferably 50°C to 230°C, more preferably 50°C to 200°C, and still more preferably 80°C to 200°C from the viewpoint of facilitating production of various electronic components (such as semiconductor devices) with high reliability. Further, from the viewpoint of reducing the warpage of the electronic component manufactured using the LCM material, an elastic modulus of the cured product measured at 30°C is preferably 5GPa to 20GPa.

The LCM material of the present embodiment is prepared by mixing and stirring the components (A) to (D) or the components (A) to (D) and other components used as necessary. For mixing and stirring, a known mixing and stirring means such as a roll mill or a planetary mixer can be appropriately used. When the epoxy resin (A) used as the raw material is solid, it is preferable that the epoxy resin (A) is liquefied or fluidized by heating or the like before being mixed with the remaining raw materials other than the epoxy resin (A).

When preparing the LCM material, mixing procedure is not particularly limited, and for example, all components used as the raw materials may be mixed at the same time, or a primary mixture may be prepared by first mixing some of the components, and then the remaining components may be added and mixed. For example, when it is difficult to uniformly disperse the inorganic filler (C) in the epoxy resin (A), the epoxy resin (A) and the inorganic filler (C) may be first mixed together to prepare a primary mixture, and then the remaining components may be mixed into this primary mixture.

The LCM material obtained by mixing and stirring the raw materials can be directly used for compression molding, but the LCM material may be subjected to defoaming treatment before being used for compression molding. Any known method can be used for the defoaming treatment without any particular limitation, and examples thereof include stirring and defoaming. The stirring and defoaming can be performed using any apparatus and under any conditions, and for example, it is preferable to stir and defoam 100 to 5000 g of the LCM material with a hard mixer (model number: UVR10L) manufactured by NIPPON SOSEY KOGYO CO., LTD. under conditions of a stirring speed of 10 to 50 rpm, a defoaming time of 60 to 120 minutes, and a degree of vacuum of 200Pa or less.

### <Electronic component, semiconductor device, and method for manufacturing electronic component>

The LCM material of the present embodiment can be used for manufacturing various products manufactured using compression molding, and specifically, can be used for manufacturing various electronic components including the sealing material. In this electronic component, the cured product of the LCM material of the present embodiment is used as the sealing material. Note that a structure of the electronic component is not particularly limited as long as the electronic component includes the sealing material, but a typical example is one having a structure including a substrate, an element disposed on the substrate, and a sealing material for sealing a gap between the substrate and the element. Specific examples of the electronic component include a semiconductor device using the wafer as the substrate and the semiconductor element as the element.

The electronic component of the present embodiment is manufactured through at least a step of compression molding using the LCM material of the present embodiment. Note that after performing the step of compression molding, usually, various post-steps such as post curing (main curing treatment), reflow, and dicing (singulation) are appropriately performed to obtain the electronic component. Further, in the compression molding, the following steps (1) to (5) are performed in this order, and the following LCM material heating step (6) is performed before starting the degassing step (4).
(1) A step of supplying the LCM material to the vicinity of the central portion of one surface of a base material selected from the group consisting of the substrate and the release film (LCM material supply step).
(2) A step of disposing the base material to which the LCM material is supplied on a lower mold surface with a surface to which the LCM material is supplied facing upward (base material disposing step).
(3) A step of relatively bringing the upper mold and the lower mold close to each other to form a sealed space between the upper mold and the lower mold (mold closing step).
(4) A step of depressurizing and degassing the sealed space (degassing step).
(5) A step of relatively bringing the upper mold and the lower mold closer to each other, and heating and pressurizing the LCM material from both upper and lower surfaces to cure the LCM material (heating and pressurizing step).
(6) A step of heating the LCM material before starting the degassing step (LCM material heating step).

Note that a method of heating the LCM material in the LCM material heating step (6) is not particularly limited, but practically, it is preferable to heat the LCM material through the base material directly in contact with the heated lower mold by previously heating the lower mold to a predetermined temperature before starting the degassing step (4) (preferably before starting the base material disposing step (2)). In this case, heating temperature of the lower mold is preferably set within a range of, for example, about 120°C±30°C. Further, when the base material to which the LCM material is supplied is the substrate, the release film is disposed on an upper mold surface, and when the base material to which the LCM material is supplied is the release film, the substrate is disposed on the upper mold surface. Further, as the substrate, a substrate having a maximum diameter smaller than a size of the mold surface on a side on which the substrate is disposed is used.

### EXAMPLES

Hereinafter, specific examples of the present invention will be described with reference to examples, but the present invention is not limited to only the examples described below.

### 1. Preparation of LCM material

A liquid resin composition was obtained by mixing and stirring raw materials using a roll mill so as to have blending amounts shown in Tables 1 to 4. Next, 500 g of the liquid resin composition was stirred and defoamed at a stirring speed of 20 rpm and a degree of vacuum of 200Pa or less at normal temperature (25°C) for 90 minutes using a hard mixer (model number: UVR10L) to prepare LCM materials of Example 1 to 15 and Comparative Example 1 to 17. However, for the LCM material prepared for evaluation of the defoaming time described later, stirring and defoaming treatment time was appropriately changed. Note that details of each component used as the raw material are as follows. Further, the blending amount of each component shown in the tables is in parts by mass.

### 2. Raw material components used for preparing LCM material

### (A) Epoxy resin

- EP-3950L (aminophenol type epoxy resin: manufactured by ADEKA Corporation)
- SE-300P (aminophenol type epoxy resin: manufactured by Shin-A T&C)
- RE-410S (bisphenol A type epoxy resin: manufactured by Nippon Kayaku Co., Ltd.)
- YDF-870GS (bisphenol F type epoxy resin: manufactured by NIPPON STEEL Chemical & Material CO., LTD.)
- YDF-8170 (bisphenol F type epoxy resin: manufactured by NIPPON STEEL Chemical & Material CO., LTD.)
- EP-3980S (aminophenol type epoxy resin: manufactured by ADEKA Corporation)
- YX-7400N (polytetramethylene glycol diglycidyl ether: manufactured by Mitsubishi Chemical Corporation)

### (B) Curing agent

- 2MZA (imidazole-based curing accelerator: manufactured by Shikoku Chemicals Corporation)
- 2P4MZ (imidazole-based curing accelerator: manufactured by Shikoku Chemicals Corporation)
- MEH-8005 (phenol novolac resin: manufactured by UBE Corporation)
- MEH-8000H (phenol novolac resin: manufactured by UBE Corporation)
- HN-5500 (methylhexahydrophthalic anhydride: manufactured by Resonac Corporation)
- MH-700 (mixture of 70% 4-methylhexahydrophthalic anhydride and 30% hexahydrophthalic anhydride: manufactured by New Japan Chemical Co., Ltd.)

### (C) Inorganic filler

- SE2200-SME (methacrylic surface-treated silica filler, average particle diameter 0.5 µm, manufactured by Admatechs Co., Ltd.)
- SE605H-SMG (methacrylic surface-treated silica filler, average particle diameter 2.0 µm, manufactured by Admatechs Co., Ltd.)
- KE-S-30-HG (silica filler, average particle diameter 0.3 µm, manufactured by NIPPON SHOKUBAI CO., LTD.)
- YA050C-SM1 (methacrylic surface-treated silica filler, average particle diameter 0.05 µm, manufactured by Admatechs Co., Ltd.)
- AG2051 SXM (phenylamino surface-treated alumina filler, average particle diameter 1 µm, manufactured by Admatechs Co., Ltd.)

### (D) Vinyl-based polymer

As the raw materials of the vinyl-based polymer used for preparing the LCM material of Examples, vinyl-based polymer antifoaming agents listed below were used. Note that the blending amount in a column of the vinyl-based polymer (D) shown in Tables 1 to 4 means the blending amount of the vinyl-based polymer (D) which is the active component (antifoaming component) contained in the vinyl-based polymer antifoaming agent. Therefore, for example, when the LCM material is prepared using 3 parts by mass of LHP-90 as the raw material, notation of the blending amount in the column of the vinyl-based polymer (D) in the tables is 1.5 parts by mass (= 3 parts by mass×0.5 (content ratio of the vinyl-based polymer as the active component)). Then, this also applies to notations in columns of blending amounts of other antifoaming agent components (D') in the tables. Note that when the content ratio of the active component in the antifoaming agents listed below is less than 100%, remaining components other than the antifoaming component contained in the antifoaming agent are all solvents.
- SN-353 (mixed liquid of vinyl-based polymer and butyl acetate (boiling point: 126°C): content ratio of vinyl-based polymer: 32 mass%: manufactured by SAN NOPCO LIMITED), number average molecular weight: 36600
- BYK-1759 (mixed liquid of foam-breaking polymer and ethyl acetate (boiling point: 77°C)): content ratio of vinyl-based copolymer: 52 mass%: manufactured by BYK-Chemie), number average molecular weight 42000
- LHP-90 (mixed liquid of vinyl-based polymer and aromatic hydrocarbon (boiling point: 155°C): content ratio of vinyl-based polymer: 50 mass%: manufactured by Kusumoto Chemicals, Ltd.), number average molecular weight 2060

### (D') Other antifoaming components

As raw materials of other antifoaming components (active components contained in the antifoaming agent) used for preparing the LCM material of Comparative Examples, the antifoaming agents listed below were used. Note that when the content ratio of the active component in the antifoaming agents listed below is less than 100%, the remaining components other than the antifoaming component contained in the antifoaming agent are all solvents.
- AF98 (silicone-based antifoaming agent: manufactured by Wacker Asahikasei Silicone Co., Ltd., active component content ratio: 100%)
- L-1982N (acrylic antifoaming agent: manufactured by Kusumoto Chemicals, Ltd., active component content ratio: 100%)
- SEI-WO1 (acrylic antifoaming agent: manufactured by Kusumoto Chemicals, Ltd., active component content ratio: 100%)
- BYK-392 (acrylic antifoaming agent: manufactured by BYK-Chemie, active component content ratio: 52%)
- BYK-354 (acrylic antifoaming agent: manufactured by BYK-Chemie, active component content ratio: 51%)
- UVX-36 (acrylic antifoaming agent: manufactured by Kusumoto Chemicals, Ltd., active component content ratio: 100%)
- L-1980N (acrylic antifoaming agent: manufactured by Kusumoto Chemicals, Ltd., active component content ratio: 100%)
- L-1984N (acrylic antifoaming agent: manufactured by Kusumoto Chemicals, Ltd., active component content ratio: 100%)
- LF-1982 (acrylic antifoaming agent: manufactured by Kusumoto Chemicals, Ltd., active component content ratio: 50%)
- SN-348 (acrylic antifoaming agent: manufactured by SAN NOPCO LIMITED, active component content ratio: 40%)
- BYK-057 (foam-breaking polymer-based antifoaming agent: manufactured by BYK-Chemie, active component content ratio: 44%)
- BYK-1794 (foam-breaking polymer-based antifoaming agent: manufactured by BYK-Chemie, active component content ratio: 100%)
- BYK-1795 (foam-breaking polymer-based antifoaming agent: manufactured by BYK-Chemie, active component content ratio: 99%)
- BYK-1799 (antifoaming agent containing hydrophobic particles and foam-breaking polysiloxane: manufactured by BYK-Chemie, active component content ratio: 98%)
- BYK-1788 (antifoaming agent containing surfactant: manufactured by BYK-Chemie, active component content ratio: 98%)
- BYK-1790 (polyolefin-based antifoaming agent: manufactured by BYK-Chemie, active component content ratio: 100%)

### 3. Various measurement and evaluation methods

For the LCM materials of Examples and Comparative Examples, the half-shot test, an amount of the warpage, the defoaming time, and the reliability were evaluated. The viscosity and the gel time of the LCM material, and the glass transition temperature (Tg) and the elastic modulus of the cured product of the LCM material were also measured. Details of these various measurement and evaluation methods will be described below.

### (Half-shot test)

The half-shot test was performed using the compression molding apparatus to evaluate the mold flash. Note that the half-shot test is a test in which the compression molding is performed under molding conditions in which the supply amount of the LCM material in the LCM material supply step (Fig. 1(A)) is further reduced and a pressurizing load in the heating and pressurizing step (Fig. 1(E)) is further reduced as compared with molding conditions (molding conditions when manufacturing an actual product such as a semiconductor device) at the time of actual compression molding in which the mold flash may occur. Therefore, as compared with the case where the compression molding is performed under actual molding conditions, a maximum diameter of the cured product of the LCM material formed on the substrate after completion of the heating and pressurizing step (Fig. 1(E)) can be further reduced, so that the evaluation test can be performed while reliably preventing the occurrence of the mold flash that damages the compression molding apparatus. In addition, since there is an extremely strong correlation between a maximum diameter Dh of the cured product of the LCM material after the completion of the heating and pressurizing step (Fig. 1(E)) in the half-shot test and a maximum diameter Dr of the cured product of the LCM material after performing the compression molding under the actual molding conditions, a value of the maximum diameter Dh measured by the half-shot test can be used to very accurately predict whether the mold flash will occur when the compression molding is performed under the actual molding conditions. As described above, the half-shot test is a test that can indirectly and simulatively evaluate the occurrence of the mold flash without damaging the compression molding apparatus.

The half-shot test was performed according to the following procedure. First, the upper mold and the lower mold of the compression molding apparatus were heated to 120°C in advance. Next, the release film was supplied to the upper mold of the compression molding apparatus and adsorbed to the upper mold. In addition, after a predetermined amount of the LCM material was supplied to a center of a silicon wafer having a diameter of 300 mm and a thickness of 780 µm, the silicon wafer was disposed on the lower mold of the compression molding apparatus. Subsequently, by raising the lower mold to a position of 124 mm, the sealed space formed between the upper mold and the lower mold was degassed for 10 seconds. Thereafter, mold clamping was started until a distance between the upper mold and the lower mold reached 500 µm while continuously degassing the sealed space. Then, degassing was terminated simultaneously with completion of the mold clamping. Subsequently, a clamping force was set to 10 kN and held for 800 seconds to cure the LCM material. Subsequently, the mold was opened, and the maximum diameter of the cured product of the LCM material formed on the silicon wafer taken out was measured.

Test conditions of the half-shot test are as follows.
- Compression molding apparatus: model: WCM-300, manufactured by Apic Yamada Co., Ltd.
- Vacuum pump (model: NeoDry15E, manufactured by Kashiyama Industries, Ltd.)
- Molding temperature: 120°C (set value)
- Cure time: 800 seconds (set value)
- Clamping force: 10 kN (set value)
- Degassing pressure: 200hPa (set value)
- Degassing setting: static degassing
- Release film: TBM (manufactured by TOWA CORPORATION)
- Mold thickness: 500 µm (set value)
- Supply amount of LCM material: 11.2 cm³

Note that when the maximum diameter of the cured product is 280 mm or more, it is confirmed that the mold flash almost certainly occurs when the compression molding is performed under the molding conditions when the actual product such as a semiconductor device is manufactured by the compression molding apparatus used in the half-shot test described above. Therefore, it is determined that the occurrence of the mold flash can be easily suppressed when the maximum diameter is less than 280 mm, and furthermore, the occurrence of the mold flash can be more reliably suppressed as the maximum diameter is smaller than 280 mm.

### (Amount of warpage)

A resin layer containing an LCM material having a diameter of 292 mm and a thickness of 500 µm was formed on a silicon wafer having a diameter of 300 mm and a thickness of 780 µm using a mold, and this resin layer was subsequently heated and cured at 150°C for 60 minutes to prepare a sample for evaluation of the warpage. Subsequently, in a state where the sample was allowed to stand on a horizontal table with a surface on which a cured layer containing the LCM material was formed facing upward, a maximum distance from a surface of the table to a lower surface of an outer peripheral end of the sample was measured using a ruler, and this value was taken as the amount of the warpage.

### (Defoaming time)

A liquid resin composition was obtained by mixing and stirring raw materials using a roll mill so as to have blending amounts shown in Tables 1 to 4. Next, 500 g of the liquid resin composition was stirred and defoamed under conditions of a stirring speed of 20 rpm and a degree of vacuum of 200Pa or less at normal temperature (25°C) using a hard mixer (model number: UVR10L) to prepare an LCM material. At this time, when 60 minutes have elapsed from start of stirring and defoaming treatment, the stirring and defoaming treatment was once stopped, whether the air bubbles remained in the LCM material was visually confirmed, and when the air bubbles were sufficiently remained, whether the air bubbles remained in the LCM material was visually confirmed again 10 minutes after the stirring and defoaming treatment was resumed. Then, visual confirmation of the air bubbles and subsequent stirring and defoaming treatment for 10 minutes were alternately repeated until the air bubbles remaining in the LCM material could not be substantially confirmed. Here, a cumulative stirring and defoaming treatment time at a time when the air bubbles remaining in the LCM material could not be substantially confirmed was taken as the defoaming time.

### (Reliability evaluation)

A prescribed amount of the prepared LCM material was supplied onto a silicon wafer having a diameter of 300 mm and a thickness of 780 µm on which the semiconductor element was disposed, and then the semiconductor element was sealed by compression molding under prescribed conditions using the compression molding apparatus. Subsequently, a semi-finished product obtained by compression molding was heated and cured at 150°C for 60 minutes to prepare a sample for reliability evaluation. The conditions used for the compression molding are as follows.
- Compression molding apparatus: model: WCM-300, manufactured by Apic Yamada Co., Ltd.
- Vacuum pump (model: NeoDry15E, manufactured by Kashiyama Industries, Ltd.)
- Molding temperature: 120°C (set value)
- Cure time: 800 seconds (set value)
- Clamping force: 250 kN (set value)
- Degassing pressure: 200hPa (set value)
- Degassing setting: static degassing
- Release film: TBM (manufactured by TOWA CORPORATION)
- Mold thickness: 500 µm (set value)
- Supply amount of LCM material: 33.5 cm³

Next, for the prepared sample for reliability evaluation, a vicinity of the interface between the semiconductor element and the sealing material (cured product of the LCM material) for sealing the semiconductor element was observed with a scanning ultrasonic microscope to confirm whether the peeling occurred at the interface between the semiconductor element and the sealing material. Evaluation criteria are as follows.
A: No peeling is observed at all at the interface between the semiconductor element and the sealing material.
B: Peeling was observed on at least a part of the interface between the semiconductor element and the sealing material.

Note that in a case where the maximum diameter of the cured product was 280 mm or more in the half-shot test (Comparative Examples 1 to 17 shown in Tables 3 and 4), the mold flash almost certainly occurred when the compression molding was performed under the molding conditions listed above simulating the molding conditions in manufacturing the actual product, and thus the reliability evaluation was not performed.

### (Viscosity at 25°C)

The viscosity of the LCM material at 25°C was measured under conditions of 25°C and 10 revolutions/min using a HB type viscometer of Brookfield.

### (Viscosity at 120°C)

The viscosity of the LCM material at 120°C was measured using a MARS rheometer manufactured by HAAKE after applying vibration at a frequency of 10 Hz to the LCM material at 120°C for 40 seconds in an oscillation strain control mode.

### (Gel time)

The gel time of the LCM material was measured under conditions of a sample amount of 0.3 ml, a rotation of 120 rpm, a revolution of 50 rpm, a gap of 0.3 mm, and a test temperature of 120°C using an automatic curing time measuring apparatus "MADOKA" (model number: MDK023) and a stirring rod (model number: 5TC-72890) manufactured by Cyber Co., Ltd.

### (Glass transition temperature Tg)

The LCM material was heated and cured at 150°C for 60 minutes to obtain a cured product. Next, a loss tangent (tanδ) of the cured product when the temperature was changed by a dynamic mechanical analysis (DMA) method using DMS6100 manufactured by Seiko Instruments Inc. (SII) was measured. Then, a temperature at which tanδ showed a maximum value was taken as the glass transition temperature of the cured product.

### (Elastic modulus)

The LCM material was heated and cured at 150°C for 60 minutes to obtain a cured product. Next, a storage modulus of the cured product was measured when the temperature was changed by the DMA method using DMS6100 manufactured by SII. At this time, the storage modulus at 30°C was taken as a value of the elastic modulus shown in the tables.

### 4. Evaluation results

Tables 1 to 4 show various measurement and evaluation results of these LCM materials and cured products thereof together with blending composition of the LCM materials of Examples and Comparative Examples.

**[Table 1]**

| LCM material constituents | Raw materials used for preparing LCM material | | Example 1 | Example 2 | Example 3 | Example 4 | Example 5 | Example 6 | Example 7 | Example 8 | Example 9 |
|---|---|---|---|---|---|---|---|---|---|---|---|
| (A) Epoxy resin | Liquid aminophenol type epoxy | EP-3950L | 11.6 | 11.6 | 11.6 | 11.6 | 11.6 | 11.6 | 11.6 | 11.6 | 11.6 |
| | Liquid bisphenol A type epoxy | RE-410S | 4.3 | 4.3 | 4.3 | 4.3 | 4.3 | 4.3 | 4.3 | 4.3 | 4.3 |
| | Polytetramethylene glycol diglycidyl ether | YX-7400N | 3.8 | 3.8 | 3.8 | 3.8 | 3.8 | 3.8 | 3.8 | 3.8 | 3.8 |
| (B) Curing agent | Imidazole-based curing agent | 2MZA | 0.8 | 0.8 | 0.8 | 0.8 | 0.8 | 0.8 | 0.8 | 0.8 | 0.8 |
| | Phenolic curing agent | MEH-8005 | 1.1 | 1.1 | 1.1 | 1.1 | 1.1 | 1.1 | 1.1 | 1.1 | 1.1 |
| (C) Inorganic filler | Surface-treated silica filler | SE2200-SME | 64.5 | 64.5 | 64.5 | 64.5 | 64.5 | 64.5 | 64.5 | 64.5 | 64.5 |
| | Surface-treated nanosilica filler | YA050C-SM1 | 12.5 | 12.5 | 12.5 | 12.5 | 12.5 | 12.5 | 12.5 | 12.5 | 12.5 |
| (D) Vinyl-based polymer (*1) | Vinyl-based polymer antifoaming agent | SN-353 (active component 32%) | 0.015 | 0.15 | 1.5 | 4.5 | | | | | |
| | Vinyl-based copolymer antifoaming agent | BYK-1759 (active component 52%) | | | | | 0.0015 | 0.015 | 0.15 | 1.5 | |
| | Vinyl-based polymer antifoaming agent | LHP-90 (active component 50%) | | | | | | | | | 1.5 |
| (E) Solvent (*2) | Various antifoaming agents used as raw materials for component (D) | | 0.03 | 0.32 | 3.20 | 9.56 | 0.001 | 0.01 | 0.14 | 1.38 | 1.50 |
| Total blending amount of all components (parts by mass) | | | 98.5 | 99.0 | 103.2 | 112.6 | 98.5 | 98.5 | 98.8 | 101.4 | 101.5 |
| Blending amount (parts by mass) of component (D) per 100 parts by mass of component (A) | | | 0.076 | 0.77 | 7.7 | 23 | 0.0076 | 0.076 | 0.76 | 7.6 | 7.6 |
| Blending ratio (mass%) of component (C) in all components | | | 78 | 78 | 75 | 68 | 78 | 78 | 78 | 76 | 76 |
| | Half-shot test (maximum diameter of cured product: mm) *3 | | 257 | 237 | 239 | 238 | 273 | 258 | 251 | 249 | 246 |
| | Reliability evaluation (presence or absence of peeling) | | A | A | A | B | A | A | A | A | A |
| | Amount of warpage (µm) | | 7200 | 5200 | 2800 | 2800 | not evaluated | 7300 | 6900 | 5700 | not evaluated |
| | Defoaming time (min) | | 120 | | | | | 120 | | | |
| Measurement and evaluation results | Viscosity at 25°C (Pa·s) | | 216 | 204 | 83.5 | not evaluated | 205.5 | 229 | 172.5 | 223.5 | 82 |
| | Viscosity at 120°C (Pa·s) | | 0.63 | 0.62 | 0.61 | not evaluated | 0.62 | 0.67 | 0.6 | 0.71 | 0.55 |
| | Gel time (sec) | | 299 | 304 | 321 | not evaluated | 307 | 295 | 305 | 316 | 307 |
| | Glass transition temperature Tg (°C) | | 165 | 171 | 143 | not evaluated | 160.2 | 162 | 158 | 157 | 132 |
| | Elastic modulus at 30°C (GPa) | | 12.1 | 12.3 | 10.9 | not evaluated | 12.1 | 12 | 12.1 | 11.9 | 11.2 |

| | | | | | | | | | | | |
|---|---|---|---|---|---|---|---|---|---|---|---|
| *1 Content derived from active component contained in antifoaming agent used as raw material *2 Content derived from solvent contained in antifoaming agent used as raw material *3 When maximum diameter of cured product is 280 mm or more is a condition that corresponds to occurrence of mold flash | | | | | | | | | | | |

**Table 2]**

| LCM material constituents | Raw materials used for preparing LCM material | | Example 10 | Example 11 | Example 12 | Example 13 | Example 14 | Example 15 |
|---|---|---|---|---|---|---|---|---|
| (A) Epoxy resin | Liquid aminophenol type epoxy | EP-3950L | | 11.6 | | | 12.8 | 11.6 |
| | Liquid aminophenol type epoxy | SE-300P | | | 2.6 | 7.1 | | |
| | Liquid bisphenol A type epoxy | RE-410S | | 4.3 | | | 5.8 | 4.3 |
| | Liquid bisphenol F type epoxy | YDF-870GS | 9.7 | | | | | |
| | Liquid bisphenol F type epoxy | YDF-8170 | | | 4.4 | | | |
| | Liquid aminophenol type epoxy | EP-3980S | | | 0.8 | 0.5 | | |
| | Polytetramethylene glycol diglycidyl ether | YX-7400N | | 3.8 | 4.1 | 3.1 | 8.1 | 3.8 |
| (B) Curing agent | Imidazole-based curing agent | 2MZA | | | | 3.0 | 1.1 | 0.8 |
| | Imidazole-based curing agent | 2P4MZ | | | 0.6 | | | |
| | Phenolic curing agent | MEH-8005 | | 1.1 | | 0.6 | 2.2 | |
| | Phenolic curing agent | MEH-8000H | | | | | | 0.6 |
| | Acid anhydride-based curing agent | HN-5500 | 9.1 | | | | | |
| | Acid anhydride-based curing agent | MH-700 | | | | | | 0.5 |
| (C) Inorganic filler | Surface-treated silica filler | SE2200-SME | 58.9 | 64.5 | | | | 64.5 |
| | Surface-treated silica filler | SE605H-SMG | | | | 71.1 | | |
| | Silica filler | KE-S-30-HG | | | | | 57.0 | |
| | Surface-treated nanosilica filler | YA050C-SM1 | 21.0 | 12.5 | 12.5 | 12.5 | 11.0 | 12.5 |
| | Surface-treated alumina filler | AG2051-SXM | | | 72.5 | | | |
| (D) Vinyl-based polymer (*1) | Vinyl-based copolymer antifoaming agent | BYK-1759 (active component 52%) | 0.073 | 0.073 | 0.073 | 0.073 | 0.073 | 0.150 |
| (E) Solvent (*2) | Various antifoaming agents used as raw materials for component (D) | | 0.07 | 0.07 | 0.07 | 0.07 | 0.07 | 0.14 |
| Total blending amount of all components (parts by mass) | | | 98.8 | 97.8 | 97.6 | 98.1 | 98.0 | 98.8 |
| Blending amount (parts by mass) of component (D) per 100 parts by mass of component (A) | | | 0.75 | 0.37 | 0.61 | 0.68 | 0.27 | 0.76 |
| Blending ratio (mass%) of component (C) in all components | | | 81 | 79 | 87 | 85 | 69 | 78 |
| | Half-shot test (maximum diameter of cured product: mm) *3 | | 202 | 217 | 234 | 221 | 199 | 213 |
| | Reliability evaluation (presence or absence of peeling) | | A | A | A | A | A | A |
| | Amount of warpage (µm) | | not evaluated | not evaluated | not evaluated | not evaluated | not evaluated | not evaluated |
| | Defoaming time (min) | | - | - | - | - | - | - |
| Measurement and evaluation results | Viscosity at 25°C (Pa·s) | | 99.5 | 139 | 165 | not evaluated | 151 | not evaluated |
| | Viscosity at 120°C (Pa·s) | | not evaluated | not evaluated | not evaluated | not evaluated | not evaluated | not evaluated |
| | Gel time (sec) | | 438 | 640 | 444 | not evaluated | 261 | not evaluated |
| | Glass transition temperature Tg (°C) | | 127 | 191 | 114 | not evaluated | 149 | not evaluated |
| | Elastic modulus at 30°C (GPa) | | 15.1 | 12 | 13.6 | not evaluated | 7.7 | not evaluated |

| | | | | | | | | |
|---|---|---|---|---|---|---|---|---|
| *1 Content derived from active component contained in antifoaming agent used as raw material *2 Content derived from solvent contained in antifoaming agent used as raw material *3 When maximum diameter of cured product is 280 mm or more is a condition that corresponds to occurrence of mold flash | | | | | | | | |

**[Table 3]**

| LCM material constituents | Raw materials used for preparing LCM material | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|---|
| (A) Epoxy resin | Liquid aminophenol type epoxy | EP-3950L | 11.6 | 11.6 | 11.6 | 11.6 | 11.6 | 11.6 | 11.6 | 11.6 | 11.6 |
| | Liquid bisphenol A type epoxy | RE-410S | 4.3 | 4.3 | 4.3 | 4.3 | 4.3 | 4.3 | 4.3 | 4.3 | 4.3 |
| | Polytetramethylene glycol diglycidyl ether | YX-7400N | 3.8 | 3.8 | 3.8 | 3.8 | 3.8 | 3.8 | 3.8 | 3.8 | 3.8 |
| (B) Curing agent | Imidazole-based curing agent | 2MZA | 0.8 | 0.8 | 0.8 | 0.8 | 0.8 | 0.8 | 0.8 | 0.8 | 0.8 |
| | Phenolic curing agent | MEH-8005 | 1.1 | 1.1 | 1.1 | 1.1 | 1.1 | 1.1 | 1.1 | 1.1 | 1.1 |
| (C) Inorganic filler | Surface-treated silica filler | SE2200-SME | 64.5 | 64.5 | 64.5 | 64.5 | 64.5 | 64.5 | 64.5 | 64.5 | 64.5 |
| | Surface-treated nanosilica filler | YA050C-SM1 | 12.5 | 12.5 | 12.5 | 12.5 | 12.5 | 12.5 | 12.5 | 12.5 | 12.5 |
| (D') Other antifoaming component (*1) | Silicone-based antifoamer | AF98 (active component 100%) | | 0.015 | | | | | | | |
| | Acrylic antifoaming agent | L-1982N (active component 100%) | | | 0.015 | | | | | | |
| | Acrylic antifoaming agent | SEI-WO1 (active component 100%) | | | | 0.015 | | | | | |
| | Acrylic antifoaming agent | BYK392 (active component 52%) | | | | | 0.015 | | | | |
| | Acrylic antifoaming agent | BYK354 (active component 51%) | | | | | | 0.015 | | | |
| | Acrylic antifoaming agent | UVX-36 (active component 100%) | | | | | | | 0.015 | | |
| | Acrylic antifoaming agent | L-1980N (active component 100%) | | | | | | | | 0.015 | |
| | Acrylic antifoaming agent | L-1984N (active component 100%) | | | | | | | | | 0.015 |
| (E) Solvent (*2) | Various antifoaming agents used as raw materials for component (D') | | 0.00 | 0.00 | 0.00 | 0.00 | 0.01 | 0.01 | 0.00 | 0.00 | 0.00 |
| Total blending amount of all components (parts by mass) | | | 98.5 | 98.5 | 98.5 | 98.5 | 98.5 | 98.5 | 98.5 | 98.5 | 98.5 |
| Blending amount (parts by mass) of component (D') per 100 parts by mass of component (A) | | | 0.00 | 0.076 | 0.076 | 0.076 | 0.076 | 0.076 | 0.076 | 0.076 | 0.076 |
| B Blending ratio (mass%) of component (C) in all components | | | 78 | 78 | 78 | 78 | 78 | 78 | 78 | 78 | 78 |
| | Half-shot test (maximum diameter of cured product: mm) *3 | | 283 | 280 | 281 | 283 | 282 | 280 | 282 | 284 | 283 |
| | Reliability evaluation (presence or absence of peeling) | | Unevaluatable | Unevaluatable | Unevaluatable | Unevaluatable | Unevaluatable | Unevaluatable | Unevaluatable | Unevaluatable | Unevaluatable |
| | Amount of warpage (µm) | | 7300 | not evaluated | not evaluated | not evaluated | not evaluated | not evaluated | not evaluated | not evaluated | not evaluated |
| | Defoaming time (min) | | 130 | 90 | 100 | 120 | 120 | 110 | 120 | 120 | 110 |
| Measurement and evaluation results | Viscosity at 25°C (Pa·s) | | 235 | 235 | 235 | not evaluated | not evaluated | not evaluated | not evaluated | not evaluated | not evaluated |
| | Viscosity at 120°C (Pa·s) | | 0.61 | 0.62 | 0.61 | not evaluated | not evaluated | not evaluated | not evaluated | not evaluated | not evaluated |
| | Gel time (sec) | | 297 | 297 | 297 | not evaluated | not evaluated | not evaluated | not evaluated | not evaluated | not evaluated |
| | Glass transition temperature Tg (°C) | | 167 | 167 | 167 | not evaluated | not evaluated | not evaluated | not evaluated | not evaluated | not evaluated |
| | Elastic modulus at 30°C (GPa) | | 12.2 | 12.2 | 12.2 | not evaluated | not evaluated | not evaluated | not evaluated | not evaluated | not evaluated |

| | | | | | | | | | | | |
|---|---|---|---|---|---|---|---|---|---|---|---|
| *1 Content derived from active component contained in antifoaming agent used as raw material *2 Content derived from solvent contained in antifoaming agent used as raw material *3 When maximum diameter of cured product is 280 mm or more is a condition that corresponds to occurrence of mold flash | | | | | | | | | | | |

**[Table 4]**

| LCM material constituents | Raw materials used for preparing LCM material | | Comparative Example 10 | Comparative Example 11 | Comparative Example 12 | Comparative Example 13 | Comparative Example 14 | Comparative Example 15 | Comparative Example 16 | Comparative Example 17 |
|---|---|---|---|---|---|---|---|---|---|---|
| (A) Epoxy resin | Liquid aminophenol type epoxy | EP-3950L | 11.6 | 11.6 | 11.6 | 11.6 | 11.6 | 11.6 | 11.6 | 11.6 |
| | Liquid bisphenol A type epoxy | RE-410S | 4.3 | 4.3 | 4.3 | 4.3 | 4.3 | 4.3 | 4.3 | 4.3 |
| | Polytetramethylene glycol diglycidyl ether | YX-7400N | 3.8 | 3.8 | 3.8 | 3.8 | 3.8 | 3.8 | 3.8 | 3.8 |
| (B) Curing agent | Imidazole-based curing agent | 2MZA | 0.8 | 0.8 | 0.8 | 0.8 | 0.8 | 0.8 | 0.8 | 0.8 |
| | Phenolic curing agent | MEH-8005 | 1.1 | 1.1 | 1.1 | 1.1 | 1.1 | 1.1 | 1.1 | 1.1 |
| (C) Inorganic filler | Surface-treated silica filler | SE2200-SME | 64.5 | 64.5 | 64.5 | 64.5 | 64.5 | 64.5 | 64.5 | 64.5 |
| | Surface-treated nanosilica filler | YA050C-SM1 | 12.5 | 12.5 | 12.5 | 12.5 | 12.5 | 12.5 | 12.5 | 12.5 |
| (D') Other antifoaming component (*1) | Acrylic antifoaming agent | LF-1982 (active component 50%) | 0.015 | | | | | | | |
| | Acrylic antifoaming agent | SN348 (active component 40%) | | 0.015 | | | | | | |
| | Foam-breaking polymer-based antifoaming agent | BYK-057 (active component 44%) | | | 0.015 | | | | | |
| | Foam-breaking polymer-based antifoaming agent | BYK-1794 (active component 100%) | | | | 0.015 | | | | |
| | Foam-breaking polymer-based antifoaming agent | BYK-179 (active component 99%) | | | | | 0.015 | | | |
| | Antifoaming agent containing hydrophobic particles and foam-breaking polysiloxane | BYK-1799 (active component 98%) | | | | | | 0.015 | | |
| | Antifoaming agent containing surfactant | BYK-1788 (active component 98%) | | | | | | | 0.015 | |
| | Polyolefin-based antifoaming agent | BYK1790 (active component 100%) | | | | | | | | 0.015 |
| (E) Solvent (*2) | Various antifoaming agents used as raw materials for component (D') | | 0.02 | 0.02 | 0.02 | 0.00 | 0.0002 | 0.0003 | 0.0003 | 0.00 |
| Total blending amount of all components (parts by mass) | | | 98.5 | 98.5 | 98.5 | 98.5 | 98.5 | 98.5 | 98.5 | 98.5 |
| Blending amount (parts by mass) of component (D') per 100 parts by mass of component (A) | | | 0.076 | 0.076 | 0.076 | 0.076 | 0.076 | 0.076 | 0.076 | 0.076 |
| Blending ratio (mass%) of component (C) in all components | | | 78 | 78 | 78 | 78 | 78 | 78 | 78 | 78 |
| | Half-shot test (maximum diameter of cured product: mm) *3 | | 282 | 280 | 282 | 285 | 283 | 280 | 284 | 280 |
| | Reliability evaluation (presence or absence of peeling) | | Unevaluatable | Unevaluatable | Unevaluatable | Unevaluatable | Unevaluatable | Unevaluatable | Unevaluatable | Unevaluatable |
| | Amount of warpage (µm) | | not evaluated | not evaluated | not evaluated | not evaluated | not evaluated | not evaluated | evaluated | not evaluated |
| | Defoaming time (min) | | 120 | 120 | 110 | 120 | 120 | 110 | 120 | 100 |
| Measurement and evaluation results | Viscosity at 25°C (Pa·s) | | not evaluated | not evaluated | not evaluated | not evaluated | not evaluated | not evaluated | evaluated | not evaluated |
| | Viscosity at 120°C (Pa·s) | | not evaluated | not evaluated | not evaluated | not evaluated | not evaluated | not evaluated | evaluated | not evaluated |
| | Gel time (sec) | | not evaluated | not evaluated | not evaluated | not evaluated | not evaluated | not evaluated | evaluated | not evaluated |
| | Glass transition temperature Tg (°C) | | not evaluated | not evaluated | not evaluated | not evaluated | not evaluated | not evaluated | evaluated | not evaluated |
| | Elastic modulus at 30°C (GPa) | | not evaluated | not evaluated | not evaluated | not evaluated | not evaluated | not evaluated | evaluated | not evaluated |

| | | | | | | | | | | |
|---|---|---|---|---|---|---|---|---|---|---|
| *1 Content derived from active component contained in antifoaming agent used as raw material *2 Content derived from solvent contained in antifoaming agent used as raw material *3 When maximum diameter of cured product is 280 mm or more is a condition that corresponds to occurrence of mold flash | | | | | | | | | | |

### LIST OF REFERENCE SIGNS

- 10: Substrate
- 20: LCM material supply means
- 30: LCM material
- 100: Compression molding apparatus
- 110: Lower mold
- 120: Upper mold
- 122: Release film
- S: Sealed space
- B: Air bubbles

## Claims

1. A liquid compression molding material comprising:
an epoxy resin (A);
a curing agent (B);
an inorganic filler (C); and
a vinyl-based polymer (D).

2. The liquid compression molding material according to claim 1, wherein a content of the vinyl-based polymer (D) with respect to 100 parts by mass of the epoxy resin (A) is 0.004 parts by mass to 15 parts by mass.

3. The liquid compression molding material according to claim 1 or 2, wherein a content of the vinyl-based polymer (D) with respect to 100 parts by mass of the epoxy resin (A) is 0.5 parts by mass to 15 parts by mass.

4. The liquid compression molding material according to any one of claims 1 to 3, wherein a blending ratio of the inorganic filler (C) to all components constituting the liquid compression molding material is 60 mass% to 90 mass%.

5. The liquid compression molding material according to any one of claims 1 to 4, wherein the vinyl-based polymer (D) contains at least one vinyl ether polymer.

6. The liquid compression molding material according to any one of claims 1 to 5, wherein the vinyl-based polymer (D) has a number average molecular weight of 1000 to 150000.

7. The liquid compression molding material according to any one of claims 1 to 6, further comprising a solvent (E).

8. The liquid compression molding material according to any one of claims 1 to 7, wherein a maximum diameter of a cured product of the liquid compression molding material obtained by a half-shot test performed under conditions of pre-stirring and defoaming for 90 minutes, a clamping force of 10 kN, a supply amount of the liquid compression molding material of 11.2 cm³, and static degassing at 200hPa is less than 280 mm.

9. The liquid compression molding material according to any one of claims 1 to 8, wherein the epoxy resin (A) contains one or more selected from the group consisting of aminophenol type epoxy, bisphenol A type epoxy, bisphenol F type epoxy, glycidylamine type epoxy, and polytetramethylene glycol diglycidyl ether.

10. The liquid compression molding material according to any one of claims 1 to 9, wherein the curing agent (B) is an imidazole-based curing agent.

11. The liquid compression molding material according to any one of claims 1 to 10, wherein a viscosity at 120°C is 0.3 Pa·s to 30 Pa·s.

12. An electronic component comprising a sealing material containing a cured product of the liquid compression molding material according to any one of claims 1 to 11.

13. A semiconductor device comprising:
a substrate;
a semiconductor element disposed on the substrate; and
a cured product of the liquid compression molding material according to any one of claims 1 to 11, the cured product sealing a gap between the semiconductor element and the substrate.

14. A method for manufacturing an electronic component, the method comprising at least a compression molding step using the liquid compression molding material according to any one of claims 1 to 11, wherein the electronic component includes a substrate, an element disposed on the substrate, and a sealing material containing a cured product of the liquid compression molding material sealing a gap between the element and the substrate.
